# EUROPEAN PATENT APPLICATION

(11) **EP 4 345 889 A1**
(43) Date of publication of application: **03.04.2024**
(21) Application number: 22198468.5
(22) Date of filing: 28.09.2022
(51) Int. Cl.: H01L 23/495, H01L 23/60

(54) **A METHOD OF IMPROVING PACKAGE CREEPAGE DISTANCE**

(71) Applicant: Nexperia B.V., 6534 AB Nijmegen (NL)
(72) Inventor: Funke, Hans-Juergen, 22529 Hamburg (DE); Shiu, Ivan, 22529 Hamburg (DE); Böttcher, Tim, 22529 Hamburg (DE)
(74) Representative: Pjanovic, Ilija

(57) **Abstract**

The present disclosure relates to a method of improving semiconductor package creepage, wherein the package comprises a semiconductor device, and a plurality of electrically conductive contacts at a surface of the package, the package comprising insulating material for electrically insulating the package between the plurality of electrically conductive contacts, wherein an initial creepage distance is defined by the shortest distance over the surface of the package between two of the plurality of contacts, and the method comprising the steps of: applying a layer of insulating material over at least part of at least one of the two contacts, wherein said insulating material is applied in a thin layer and selected to obtain a package thermal resistance increase less than a factor 3 as compared to an uncoated semiconductor package, to increase the initial creepage distance and improve package creepage of the semiconductor package.

## Description

### Technical field

The present disclosure is directed to a method improving package creepage distance for a integrated circuit package, in particular for high voltage devices.

### Background

Creepage and clearance are typical industry standard critical properties for packages of discrete semiconductors and Integrated Circuits, ICs.

Clearance may be defined as the shortest distance in air between two conductors. Hence, as the shortest distance is through air, it can be understood as, or comparable to the line of sight between to peaks, i.e. given no obstacles between two conductors, it is the shortest distance between the conductors.

Creepage is closely related to clearance however and may be defined as the shortest distance between two conductors along the surface of the insulating material. Hence, in comparison with the example of clearance, instead of the shortest distance over air, the shortest distance over land between the two peaks.

Especially for high voltage devices the creepage and also clearance are very important, and with the trend in increase in voltages of the devices, which may even exceed 500V, and trend of miniaturization of semiconductor device packages, creepage and clearance becomes even more important.

Insufficient creepage may result in voltage breakdown in which the voltage between two conductors overcomes the insulation in between the conductors and may create an arc or conductive path across the surface of the insulating material which can damage the device, cause failure of the operation of the device and may cause hazardous situations.

Creepage properties can be improved by increasing the distance between the two conductors. Typically, that will increase the package size, which is contrary to the desire for miniaturization. Alternatively, creepage properties may be improved by adding plastics over exposed conductive parts of the package. This however requires additional measure to be taken in the assembling of the end user device. Yet another alternative to improve creepage properties is the use of leadframes package designs, which however result in reduction of heatsink size, which in turn has decreases thermal properties of the package.

### Summary

It is an object of the present disclosure, to provide for a method of improving creepage properties for semiconductor package, especially for high voltage applications, which does not result in increase of spacing between conductors of the package, and wherein disadvantages related to known creepage property improving methods are resolved.

In a first aspect, there is provided a method of improving semiconductor package creepage, wherein the package comprises a semiconductor device, and a plurality of electrically conductive contacts at a surface of the package, the package comprising insulating material for electrically insulating the package between the plurality of electrically conductive contacts, wherein an initial creepage distance is defined by the shortest distance over the surface of the package between two of the plurality of contacts, and the method comprising the steps of:
- applying a layer of insulating material over at least part of at least one of the two contacts, wherein said insulating material is applied in a thin layer and selected to obtain a package thermal resistance increase less than a factor 3 as compared to an uncoated semiconductor package, to increase the initial creepage distance and improve package creepage of the semiconductor package.

Safety and reliability are two important measures in the design and use of semiconductor devices, especially for high voltage applications. In general these measures may relate to the packages which house the semiconductor devices, and to the Printed Circuit Boards, PCB, on which the semiconductor packages or devices are mounted (e.g. soldered).

Creepage and clearance are two typical properties for both the PCB and the packages which have a high impact on the reliability and the safety. As such, certain applications, environments and/or designed maximum operating voltage levels may require certain levels of creepage and clearance.

Certain commonly used semiconductor packages have standard pin-to-pin clearance and creepage distances. Newer versions of the same package standard may further increase pin-to-pin clearance to improve safety and reliability and/or to set higher maximum voltage levels.

Further improvement is challenging as it may require complex modification to the package, for example by introducing grooves, notches or slots into the package to increase the path between two conductors and thereby improve creepage properties of the package.

High voltage applications are typical application in which creepage is a critical property of the package. Typically, the packages for such applications, as for example a TO220 style package, have two or three leads and a metal tab like surface which may allow mounting to an external heatsink and functions as a heatsink to allow the device to dissipate heat.

Improving creepage distance by modification of such packages may have an impact on the heat dissipation capabilities of the device, which especially for high voltage packages and thus high power applications may be a problem.

It was the insight of the inventors that improvement of the creepage properties, by increasing the creepage distance, should be achieved through coating the conductive parts of the package, or at least part thereof and on at least one of the conductive parts, with a material selected on the basis of both electrical insulation as well as thermal conductivity. Typically, materials having high degree of electrical insulation also have a high degree of thermal insulation. What is proposed, is to apply only a thin layer of coating. The coating is applied in such a way, that the electrical conductivity is decreased only to a limited degree, or preferably not decreased at al. This can be achieved through application of various materials in a thin layer, and to such an extent that a package thermal resistance increase is less than a factor 3, when compared to an uncoated semiconductor package.

Hence, on the one hand the electrical conductivity or insulation meets the requirements to be considered an insulator for determining the creepage, which thus increases creepage distance, whereas on the other hand, the layer is sufficiently thin that the material selected will lower thermal conductivity only to a limited extent, not exceeding a factor 3 as defined by the package thermal resistance, and preferably, not exceeding a factor 2, such that the heat dissipation requirements of the device are only to a small degree affected, still within specification but with improved creepage properties.

In an example the insulating material is applied in a thin layer and selected to obtain a package thermal resistance increase less than a factor 2 as compared to an uncoated package.

In an example the insulating material is selected by having an electrical volume resistivity in the range of 1 × 10¹⁶ to 1 × 10¹⁸, more preferably in the range of 5 × 10¹⁶ to 5 × 10¹⁷, and most preferably in the range of 8 × 10¹⁶ to 2 × 10¹⁷ Ω-cm.

In an example the insulating material is selected from one of the group of: Al2O3/TiO2, Parylene, polyimide or other polymer materials as used for conformal coating of PCBs in electronic equipment.

In an example the insulating material after application has a thickness of less than 100µm, more preferably less than 10 µm, most preferably less than 1 µm.

In an example the insulating material is being applied by Atomic Layer Deposition, ALD.

In an example the insulating material is being applied by a deposition method, preferably a vacuum deposition method, and more preferably a chemical vapor deposition method.

In an example the insulating material is being applied by sputtering.

In an example the insulating material is being applied by spraying.

In an example the insulating material is being applied to a part of one of the contacts.

In an example the insulating material is being applied to cover all of the surface of one of the contacts.

In an example the insulating material is being applied to cover all of the surface of plural contacts of the package.

In an example one of the contacts is a heatsink of the semiconductor package.

In an example one of the contacts is a package lead.

In an example the device is a discrete Surface-Mounted Device, SMD, semiconductor device or a discrete Through Hole Package, THP, semiconductor device.

In a second aspect, there is provided a semiconductor package having a coating applied over at least part of at least one contact of the semiconductor package, wherein the application of the coating is performed in accordance with the first aspect of the present disclosure.

The definitions and advantages of the first aspect of the present disclosure are also applicable to any of the other aspects of the present disclosure.

The above and other aspects of the disclosure will be apparent from and elucidated with reference to the examples described hereinafter.

### Brief description of the drawings

Fig. 1a and 1b disclose a semiconductor package;
Fig. 2 discloses the steps of a method of improving semiconductor package creepage in accordance with a first aspect of the present disclosure;
Fig. 3 discloses a semiconductor package with improved creepage properties according to a first embodiment;
Fig. 4 discloses a semiconductor package with improved creepage properties according to a second embodiment;
Fig. 5 discloses a semiconductor package with improved creepage properties according to a third embodiment;
Fig. 6 discloses a semiconductor package with improved creepage properties according to a second embodiment.

### Detailed Description

It is noted that in the description of the figures, same reference numerals refer to the same or similar components performing a same or essentially similar function.

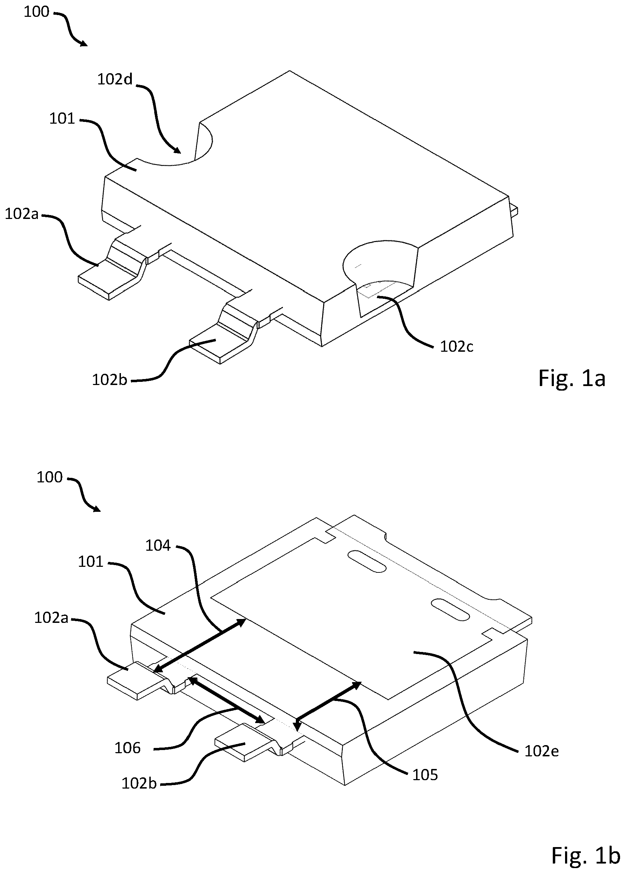

Fig. 1a and 1b disclose a typical semiconductor package 100 comprising discrete semiconductor components or Integrated Circuit(s), IC(s).

The semiconductor package 100 comprises the semiconductor device, and a plurality of electrically conductive contacts 102a, 102b, 102c, 102d, 102e at a surface of the package. These contacts are conductive and exposed, as can been seen in Fig. 1a and 1b. The package 100 shown here by way of example, has two leadframes or leadframe strips, or simply leads 102a, 102b. The example shown in Fig. 1a, 1b also has two notches 102c, 102d, which are used for molding the package and a heatsink 102e or contact surface for fixing the package 100 onto an external heatsink (not shown). The semiconductor package further comprises insulating material 101 for electrically insulating the package 100 between the plurality of electrically conductive contacts 102a-e.

Creepage is a typical industry standard critical property for packages of discrete semiconductors and Integrated Circuits, ICs. Creepage may be defined as the shortest distance between two conductors along the surface of the insulating material. When looking at Fig. 1b, there are two types of creepage, the creepage distance on the PCB 104, which may also be defined as the clearance as the shortest distance through air between two electrically conductive surfaces of the package, and creepage distance on the package 105, which is the shortest distance over the surface of the package between two electrically conductive surfaces of the package. The proposed method to improve creepage properties, may improve one but preferably both of the creepage distance on the PCB 104 and the creepage distance on the package 105.

In Fig. 1a, 1b the creepage 104, 105, 106 prior to the method according to the present disclosure, is defined as the initial creepage distance. Which is thus the shortest distance between two of a plurality of contacts of the package, in the example shown in Fig 1b, the distance 104 between 102a and 102e, and/or the distance 105 between 102b and 102e and the distance 106 between 102a and 102b. When the method is performed, the package creepage of the semiconductor package is improved, without having to modify the package design, materials or processing of the package.

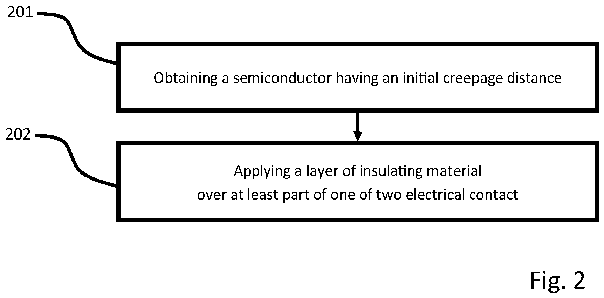

Fig. 2 discloses the basic steps 201, 202 of a method of improving semiconductor package creepage. The semiconductor package comprises a semiconductor device, and a plurality of electrically conductive contacts at a surface of the package. The semiconductor package further comprises insulating material for electrically insulating the package between the plurality of electrically conductive contacts.

In step 201 a semiconductor package having discrete semiconductors and/or integrated circuits is provided. The package, without performing the method according to the present disclosure, has an initial creepage distance.

In step 202 a layer of insulating material is applied over at least part of at least one of the two contacts. Hence, the package has electrical contacts, being the heatsink 102e of the package, the leadframe strips 102a, 102b, dam bar area, or any other exposed conductive, e.g. metal, parts of the package such as the mould notches 102c, 102d. The layer of insulating material is thus a coating and is thus applied to at least one of the conductive elements or exposed conductive areas of the package. The insulating material or coating may cover part or all of the exposed area.

The coating is applied in accordance with step 202 in a thin layer, e.g. less than 100µm, more preferably less than 10 µm, most preferably less than 1 µm, and may comprise one or more of Al2O3/TiO2, Parylene, polyimide or other polymer materials as used for conformal coating of PCBs in electronic equipment.

Applying any layer of insulating material over the exposed conducting area, either fully covering the area or partly covering it, will lower electrical conductivity, however, the coating is applied in such a way, that the thermal conductivity, due to the layer thickness, is increased to a larger degree than the electrical conductivity. This can be achieved through application of various materials in a thin layer, and to such an extent that a package thermal resistance increase is less than a factor 3, or preferably to a factor 2, when compared to an uncoated semiconductor package. Accordingly, the initial creepage distance is increased and the overall package creepage of the semiconductor package is improved.

With the method according to the present disclosure, thermal resistance is increased with of a factor 3 or 2 of the initial thermal resistance of the package, such a package on the one hand meets minimum creepage distance of electrical conductors as described e.g., in IEC60664-1 and IPC2221A, whereas on the other hand, the thermal resistance is still within prescribed range to meet packaging requirements. Hence, the thermal path for the package for cooling is electrically isolated, to such a degree that the creepage properties are improved but with minimal, and at least within specification, reduction in thermal such a way that the thermal conductivity.

The coating may be applied in full, or partially, on one of the exposed electrical contacts, or on several or all of the electrical contacts such as on the heatsink. The coating can be applied in addition or alternatively also at the leads (e.g., at area of dambar remains) close to package or on top of the exposed metal parts of mould notch.

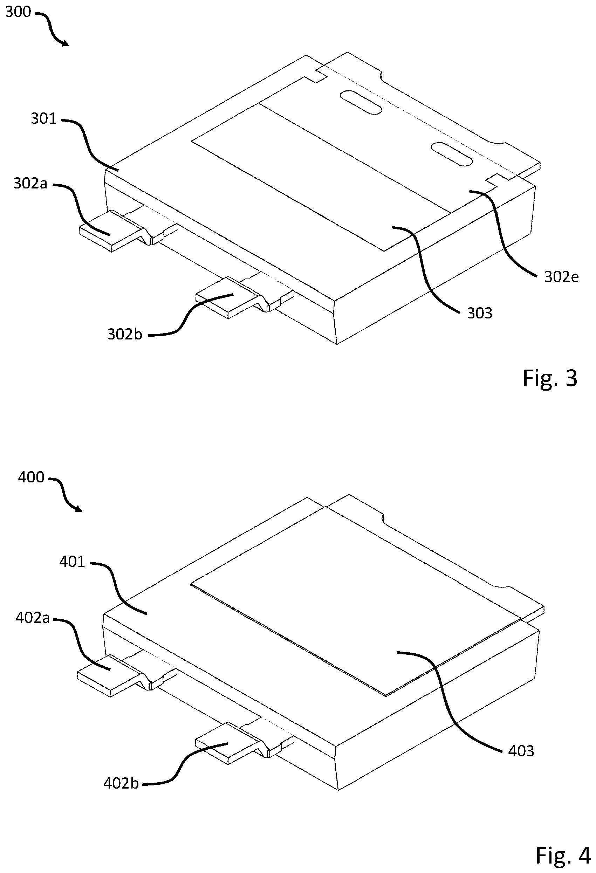

In Fig. 3, 4, 5 and 6 four different examples 300, 400, 500, 600 are shown of a package on which the method of the present disclosure is applied. In order to reduce the required creepage distances according to insulation coordination for electrical equipment, metal parts (e.g. leads or heatsinks) are according to the present disclosure partially or fully coated by a material like an ALD layer, parylene or other insulating coating materials like conformal coating materials. The coating material has a CTI value according to material group 1 (refer IEC60664-1) to minimize the required distances of metal parts of the package. ALD coating materials like Al2O3/TiO2 will not track at all.

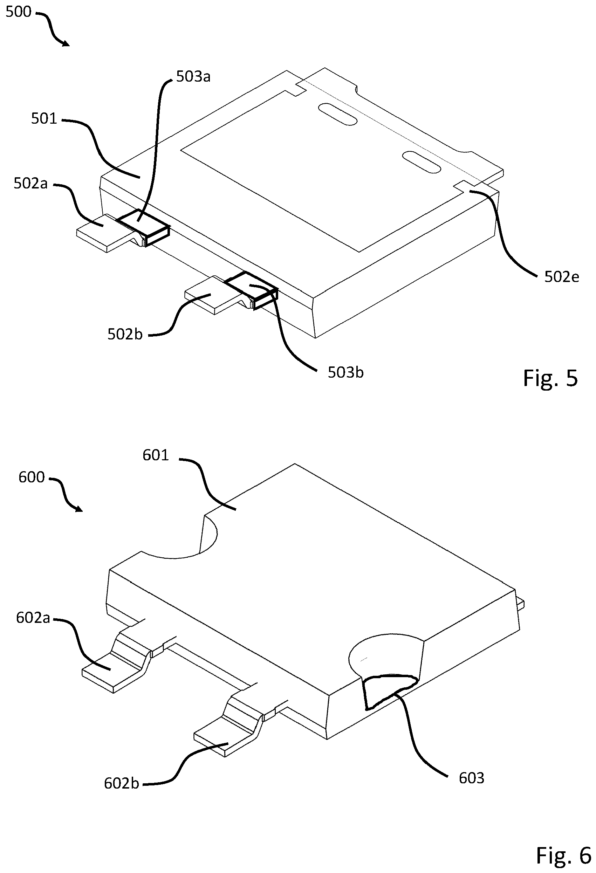

There are four different example to apply a coating according to the present disclosure on a package:
a) Partially coating 303 the heatsink 302e of a SMD package 300 to increase the creepage distance between heatsink 302e and leads 302a, 302b (as shown in Fig. 3);
b) Full coverage 403 of a heatsink of a SMD 400, through hole or top-cool package to achieve electrical insulation towards a mounted external heatsink (as shown in Fig. 4);
c) Coating 503a, 503b of the leads 502a, 502b, and part of plastic body 501 at which the leads enter the plastic body (e.g., at dam bar area) to increase the creepage distance between the leads (as shown in Fig. 5);
d) Coating 603 of the exposed metal parts of a mould notch to avoid exposed metal parts with high voltage potential (as shown in Fig. 6).

The coating material as applied to metal parts of plastic body of the packages comprise a material such as Al2O3/TiO2 applied by ALD (atomic layer deposition), Parylene, polyimide or other polymer materials as used for conformal coating of PCBs in electronic equipment. The skilled person will appreciate how such coatings are applied, which process is thus not further described in the present disclosure, as application on semiconductor packages is done in the same way.

Fig. 3 shown an example of a partial coating 303 of the heatsink 302e of a SMD package 301 to increase the creepage distance of the leads. The way of processing and coating position in the assembly flow will be as described under a).

The assembly process of the semiconductor package 300, 400, 500, 600 will be done in the usual way until moulding of the leadframe strips or other exposed electrical contacts. Individual packages have been built and will still be on leadframe strips. Prior to galvanic tin plating the heatsinks of the packages will be coated with one of the above-mentioned materials. Coverage of the parts of packages and leadframe at which the coating should be not applied needs to be done prior to coating process. After coating the ongoing processing of the leadframe strips can be done in usual way. As an alternative, the coating of the exposed package heatsinks can be done on the moulded leadframe strips after galvanic tin plating. As an alternative, the coating of the exposed package heatsinks can be done on the moulded leadframe strips after galvanic tin plating and singulation in individual packages.

The part(s) of the exposed package heatsink or other electrically conductive contacts that should be kept uncoated, are covered with a protective layer during the coating process. As result the uncoated part of the heatsink will remain electrically conductive and as well the thermal conductivity will be not impacted at this uncoated area. The advantage of this method is to increase the creepage distance towards other metal conductors (e.g., package leads). Such method of coating and protecting the uncoated area's may apply to the example disclosed in Fig. 3 but the skilled person will appreciate that is also applies to the examples disclosed in Fig. 4, 5 and 6.

In Fig. 4 another example 400 is shown of coating a package 401, in which a full coverage 403 of a heatsink of a SMD, through hole or topcool package 400 is applied, to achieve electrical insulation towards a mounted external heatsink and leads 402a, 402b.

Fig. 5 shows yet another example of coating the leads and preferably part of plastic body at which the leads enter the plastic body (e.g., at dam bar area) to increase the creepage distance between the leads. As mentioned, the way of processing and position in the assembly flow, may be similar as described in relation to the example of Fig. 3. For this example, the area of leads close to plastic body will be coated 503a, 503b too, on all sides of the leads 502a, 502b. The rest of the package and leadframe parts needs to be covered to remain uncoated. The example shown in Fig. 5 solves the following issues:
- Due to punching operation for removing the dam bars there will be always some remains which reduce the clearance from lead to lead. The coating will isolate the dam bar remains and air to air clearance distance of uninsulated metal parts is not applicable anymore.
- At the position at which the leads enter the plastic body the creepage distance on mould compound surface is determined by the distance of the leads. By coating of leads and plastic body at this area the tracking properties will be improved to be as good as the coating. That will reduce the required creepage distance according to the relevant standards (e.g., IEC60664 or IPC2221A)

Fig. 6 shows yet another example of coating 603 of the exposed metal parts of mould lock or mould notch features 102c, 102d, to avoid exposed metal parts with high voltage potential. The coating of this example has the effect that the exposed metal parts at the package at which some mould tool feature press down the die pad to bottom mould to avoid plastic resin coverage on the heatsink (exposed Cu parts on back heatsink/packages). At this location the Cu of the die pad will remain exposed and is connected to electrical potential. Coating of the metal parts at this area will be used to isolate this areas and will help to increase creepage distances in final application.

In any of the examples described, ALD may be used to apply Al2O3/TiO2 or parylene in very thin layers. Especially for ALD the coating layer can be in sub µm thickness. This minimizes the impact of the thermal conductivity from package heatsink to external heatsink by maintaining electrical isolation. Also, partially coverage of package metal parts is possible by the proposed method. No modification on package design, materials or processing is necessary. The proposed method allows to select mould compounds with optimal properties for e.g., adhesion (zero delamination) and best thermo-mechanical performance with more freedom on creepage related properties (material class), without requiring additional steps after manufacturing. E.g. conformal coating of complete assembled PCB can be skipped. As such, a flexible increase of high voltage creepage distances of semiconductor plastic packages may be achieved by partial or full conformal coating of metal parts. The proposed method may be applied on a large variety of packages and for various applications, amongst which:
- Discrete Packages and Modules for SiC devices
- SMD discrete semiconductor components
- THP discrete semiconductor components
- Electronic passive components
- Modules
- System in packages (SIP)
- etc.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope thereof.

### LIST OF ELEMENTS IN THE DRAWINGS

- 100: semiconductor device
- 101: insulating material
- 102a: first lead
- 102b: second lead
- 102c: first mould notch
- 102d: second mould notch
- 102e: heatsink
- 104: creepage distance
- 105: creepage distance
- 106: creepage distance
- 201: first step of the method
- 202: second step of the method
- 300: semiconductor device according to first embodiment
- 301: insulating material
- 302a: first lead
- 302b: second lead
- 302e: uncoated heatsink section
- 303: partly coated heatsink
- 400: semiconductor device according to second embodiment
- 401: insulating material
- 402a: first lead
- 402b: second lead
- 403: fully coated heatsink
- 500: semiconductor device according to third embodiment
- 501: insulating material
- 502a: first lead
- 502b: second lead
- 503a: partly coated first lead
- 503b: partly coated second lead
- 502e: heatsink
- 600: semiconductor device according to fourth embodiment
- 601: insulating material
- 603: fully coated first mould notch
- 602a: first lead
- 602b: second lead

## Claims

1. A method of improving semiconductor package creepage, wherein the package comprises a semiconductor device, and a plurality of electrically conductive contacts at a surface of the package, the package comprising insulating material for electrically insulating the package between the plurality of electrically conductive contacts, wherein an initial creepage distance is defined by the shortest distance over the surface of the package between two of the plurality of contacts, and the method comprising the steps of:
- applying a layer of insulating material over at least part of at least one of the two contacts, wherein said insulating material is applied in a thin layer and selected to obtain a package thermal resistance increase less than a factor 3 as compared to an uncoated semiconductor package, to increase the initial creepage distance and improve package creepage of the semiconductor package.

2. The method of improving semiconductor package creepage according to claim 1, wherein said insulating material is applied in a thin layer and selected to obtain a package thermal resistance increase less than a factor 2 as compared to an uncoated package.

3. The method of improving semiconductor package creepage according to claim 1 or 2, wherein said insulating material is selected by having an electrical volume resistivity in the range of 1 × 10¹⁶ to 1 × 10¹⁸, more preferably in the range of 5 × 10¹⁶ to 5 × 10¹⁷, and most preferably in the range of 8 × 10¹⁶ to 2 × 10¹⁷ Ω-cm.

4. The method of improving semiconductor package creepage according to any of the claims, wherein the insulating material is selected from one of the group of: Al2O3/TiO2, Parylene, polyimide or other polymer materials as used for conformal coating of PCBs in electronic equipment.

5. The method of improving semiconductor package creepage according to any of the claims, wherein the insulating material after application has a thickness of less than 100µm, more preferably less than 10 µm, most preferably less than 1 µm.

6. The method of improving semiconductor package creepage according to any of the claims, wherein the insulating material is being applied by Atomic Layer Deposition, ALD.

7. The method of improving semiconductor package creepage according to any of the claims, wherein the insulating material is being applied by a deposition method, preferably a vacuum deposition method, and more preferably a chemical vapor deposition method.

8. The method of improving semiconductor package creepage according to any of the claims, wherein the insulating material is being applied by sputtering.

9. The method of improving semiconductor package creepage according to any of the claims, wherein the insulating material is being applied by spraying.

10. The method of improving semiconductor package creepage according to any of the claims, wherein the insulating material is being applied to a part of one of the contacts.

11. The method of improving semiconductor package creepage according to any of the claims, wherein the insulating material is being applied to cover all of the surface of one of the contacts.

12. The method of improving semiconductor package creepage according to any of the claims, wherein the insulating material is being applied to cover all of the surface of plural contacts of the package.

13. The method of improving semiconductor package creepage according to any of the claims, wherein one of the contacts is a heatsink and/or one of the contacts is a package lead of the semiconductor package.

14. The method of improving semiconductor package creepage according to any of the claims, wherein the device is a discrete Surface-Mounted Device, SMD, semiconductor device or a discrete Thin High Phosphorus, THP, semiconductor device.

15. A semiconductor package having a coating applied over at least part of at least one contact of the semiconductor package, wherein the application of the coating is performed in accordance with any of the previous claims 1-14.
